# EUROPÄISCHE PATENTANMELDUNG

(11) **EP 3 396 583 A1**
(43) Veröffentlichungstag der Anmeldung: **31.10.2018**
(21) Anmeldenummer: 17168252.9
(22) Anmeldetag: 26.04.2017
(51) Int. Cl.: G06K 7/00

(54) **SYSTEM UND VERFAHREN ZUR HERSTELLUNG UND ÜBERWACHUNG EINER LEITUNGSVERBINDUNG ZWISCHEN ZWEI SYSTEMGERÄTEN**

(71) Anmelder: KTS Kommunikationstechnik und Systeme GmbH, 41238 Mönchengladbach (DE)
(72) Erfinder: Kotyrba, Gregor, 47877 Willich (DE)
(74) Vertreter: Meyer, Ludgerus

(57) **Zusammenfassung**

Die Erfindung betrifft ein System und ein Verfahren zur Herstellung und Überwachung einer Leitungsverbindung (3) zwischen zwei Systemgeräten (1, 2), von denen wenigstens eines der Systemgeräte mit einem Kupplungsanschluss versehen ist, mit dem die Leitungsverbindung (3) verbindbar ist, wobei die Zuordnung der Leitungsverbindung (3) zu dem Kupplungsanschluss über eine RFID-Kopplung identifizierbar ist, und ein Auswertesystem (11) zur Erfassung und Überwachung des Verbindungszustandes einer Vielzahl von Leitungsverbindungen und Systemgeräten vorgesehen ist. Erfindungsgemäß ist der Kupplungsanschluss wenigstens eines der Systemgeräte mit einem RFID- Transponder (7, 8) versehen, der Leitungsverbindung (3) ist eine mit dem Auswertesystem (11) verbindbare Empfangseinheit (4) zur Auswertung der Kommunikation mit dem RFID-Transponder (7, 8) zugeordnet und die Empfangseinheit (4) ist mit einem Energiespeicher versehen oder mit einer Energieversorgungseinheit koppelbar.

## Beschreibung

Die Erfindung bezieht sich zunächst auf ein System zur Herstellung und Überwachung einer Leitungsverbindung zwischen zwei Systemgeräten nach dem Oberbegriff des Anspruchs 1.

Die Erfindung betrifft ferner eine Leitungsverbindung zur temporären Verbindung zweier Systemgeräte sowie ein Verfahren zur Herstellung und Überwachung einer Leitungsverbindung zwischen zwei Systemgeräten.

Die Telekommunikationstechnik verwendet heute vielfach Kabelmanagementsysteme, über die Leitungsverbindungen zwischen Systemgeräten auf ihren Verbindungszustand überwacht werden können. Des Weiteren werden solche Managementsysteme dazu verwendet, Leitungsverbindungen auf einfache Weise herstellen oder umpatchen zu können, auch wenn in einem Schaltschrank oder an einem Verteilerfeld eine Vielzahl von Leitungsverbindungen vorhanden sind.

Die Herstellung einer korrekten Verbindung wird wesentlich erleichtert, wenn Systemgeräte, wie Patchpanel, Switches, Computer und andere Systemgeräte mit RFID-Readern versehen werden, die in Kommunikationsverbindung mit RFID-Transpondern an Leitungsverbindungen treten und auf diese Weise eine korrekte oder fehlerhafte Zuordnung zwischen der Leitungsverbindung und einem Systemgerät erkennen können.

Aus der DE 102 44 304 B3 ist eine Anordnung zur Überwachung von Patchfeldern an Verteilerpunkten in Datennetzwerken bekannt geworden, bei der jeder Anschluss in einem Patchfeld mit einer Readerspule oder mit einem Reader ausgerüstet ist und die Reader in Datenverbindung mit einer Auswerteeinheit stehen. Jede Spule bzw. jeder Reader ist dabei einer einzelnen Steckkupplung des Patchfeldes zugeordnet. Die Leitungsverbindungen sind dabei mit RFID-Chips versehen, die von den Readerspulen ausgelesen werden können. Bei hergestellter Steckverbindung kann überwacht werden, ob die Verbindung ordnungsgemäß erfolgt ist und weiter besteht.

Bei einem aus der EP 2 333 691 A1 bekannten System enthält eine Leitungsverbindung eine Antennenanordnung, die in Kommunikationsverbindung mit einem an einem Systemgerät angeordneten RFID-Transponder steht. Die Leitungsverbindung weist dazu zwei Antennen auf, die elektrisch miteinander verbunden sind, von denen eine in drahtloser Funkverbindung mit einer Sendeempfangseinheit in einem Systemgerät und die andere Antenne in Sendeempfangsverbindung mit einem Transponder steht, der an einem anderen Systemgerät angeordnet ist. Mit einer derartigen Leitungsverbindung lässt sich ein Systemgerät identifizieren und die angeschlossene Leitungsverbindung nachverfolgen.

Vorgenannte Systeme verwenden entweder RFID-Chips an den Enden von Leitungsverbindungen mit der Notwendigkeit, RFID-Reader an den Kupplungen der Systemgeräte anzubringen oder es ist erforderlich, in einem der Systemgeräte einen RFID-Reader anzuordnen, während am anderen Ende der Leitungsverbindung ein Systemgerät mit einem RFID-Transponder angeordnet ist.

Bei heute vielfach in der Kommunikationstechnik, aber auch in der allgemeinen Industrie verwendeten Systemgeräten, wie Wandanschlussdosen, Kameras, Aktuatoren, Sensoren und ähnlichen Geräten, ist entweder der verfügbare Platz zur Anordnung einer Readerspule zu klein, es ist keine Energieversorgung vorhanden oder es besteht keine Möglichkeit, standardisierte Auswertesysteme (z. B. RFID-Reader) zu montieren, die mit Managementsystemen in Verbindung treten können.

Der Erfindung liegt daher die Aufgabe zugrunde, ein System zur Herstellung und Überwachung einer Leitungsverbindung zwischen zwei Systemgeräten anzugeben, bei dem es nicht erforderlich ist, eine RFID-Leseeinheit oder eine Readerspule in einem Systemgerät unterzubringen, aber es gleichwohl möglich ist, ein Systemgerät zu identifizieren und die Zuordnung einer Leitungsverbindung zu einem Systemgerät zu überwachen und auszuwerten.

Diese Aufgabe wird durch im Anspruch 1 angegebene Merkmale der Erfindung gelöst.

Der Erfindung liegt weiterhin die Aufgabe zugrunde, eine Leitungsverbindung zur temporären Verbindung zweier Systemgeräte zur Übertragung von Daten, elektrischer Energie, fließfähigen Stoffen oder Gasen zwischen Systemgeräten anzugeben, bei deren Einsatz zur Verbindung zwischen zwei Systemgeräten der erforderliche Aufwand an den Systemgeräten zu ihrer Identifizierung sehr gering gehalten werden kann.

Des Weiteren liegt der Erfindung die Aufgabe zugrunde, ein Verfahren zur Herstellung und Überwachung einer Leitungsverbindung zwischen zwei Systemgeräten anzugeben, mit dem Systemgeräte einfach identifiziert werden können und Leitungsverbindungen zwischen den Systemgeräten überwacht und ausgewertet werden können.

Diese Aufgaben werden durch die in den Ansprüchen 13 und 14 angegebene Erfindung gelöst.

Vorteilhafte Weiterbildungen der Erfindung sind in den jeweiligen Unteransprüchen angegeben.

Bei einem System zur Herstellung und Überwachung einer Leitungsverbindung zwischen zwei Systemgeräten nach dem Oberbegriff des Anspruchs 1 ist wenigstens eines der Systemgeräte mit einem Kupplungsanschluss versehen, mit dem die Leitungsverbindung verbindbar ist, wobei die Zuordnung der Leitungsverbindung zu dem Kupplungsanschluss über eine RFID-Kopplung identifizierbar ist. Ferner ist ein Auswertesystem zur Erfassung und Überwachung des Verbindungszustands einer Vielzahl von Leitungsverbindungen zwischen Systemgeräten vorgesehen.

Erfindungsgemäß ist der Kupplungsanschluss wenigstens eines der Systemgeräte mit einem RFID-Transponder versehen. Der Leitungsverbindung ist eine mit einem Auswertesystem verbindbare Empfangseinheit zur Auswertung der Kommunikation mit dem RFID-Transponder zugeordnet. Die Empfangseinheit ist mit einem Energiespeicher versehen oder mit einer Energieversorgungseinheit koppelbar.

Dadurch, dass die Leitungsverbindung selbst eine aktive Empfangseinheit zur Auswertung der Kommunikation mit dem RFID-Transponder enthält, benötigt keines der zu verbindenden Systemgeräte eine eigene RFID-Leseeinheit oder einen Anschluss an eine Auswerteeinheit. Vielmehr genügt es, die Systemgeräte mit RFID-Transpondern zu versehen, durch die die Systemgeräte identifizierbar sind. Die an der Leitungsverbindung angeordnete Empfangseinheit ist dabei eine aktive Einheit, die in direkte Kommunikation mit einem Auswertesystem treten kann, welche durch ein in der Regel softwaremäßig realisierbares Kabelmanagementsystem verwirklicht ist. Die Kommunikation zwischen Empfangseinheit und Auswertesystem kann funkbasiert durchgeführt sein, sofern die entsprechenden räumlichen Voraussetzungen gegeben sind. Die Übertragung der Auswertesignale kann jedoch auch über die Leitungsverbindung selbst erfolgen, vorzugsweise paketweise, oder auch drahtlos über vermaschte Netzwerke nach verschiedenen Standards. Da die Empfangseinheit eine aktive Einheit ist, wird eine Energieversorgung benötigt, die entweder durch einen internen Energiespeicher realisiert ist oder Energie aus einer Energieversorgungseinheit enthält. Als Energiequelle ist auch eine POE-Verbindung möglich.

Wenn die Leitungsverbindung mit einer Empfangseinheit und an einem oder beiden Enden jeweils eine Antennenspule zur Funkverbindung mit RFID-Transpondern in dem Systemgerät oder den Systemgeräten aufweist, sind die Antennenspulen elektrisch mit der Empfangseinheit verbunden. Die Leitungsverbindung benötigt damit lediglich eine einzige Empfangseinheit, während die Empfangsantennen an beiden Enden der Leitungsverbindung angeordnet sind und in elektrischer Verbindung zur Empfangseinheit stehen.

In einer alternativen Ausbildungsform weist die Leitungsverbindung an einem oder beiden Enden jeweils eine Antennenspule zur Funkverbindung mit RFID-Transpondern in einem Systemgerät auf, bei der jeder Spule eine eigene Empfangseinheit zugeordnet ist. Eine solche Ausbildung hat insbesondere bei langen Leitungsverbindungen Vorteile, da jeweils nur an den Enden der Leitungsverbindung eine Empfangseinheit mit zugehöriger Spule angeordnet sein muss. Hierbei ergibt sich auch der Vorteil, dass die Empfangseinheit und die Antennenspule an den Enden der Leitungsverbindung lösbar, z. B. über einen Clip, angebracht werden können. Dadurch ist bei dem erfindungsgemäßen System auch ein nachträgliches Aufrüsten von vorhandenen Leitungsverbindungen möglich. Die Energieversorgung der Empfangseinheit oder der Empfangseinheiten kann über Energiespeicher, wie Batterien, hergestellt werden oder auch durch Verwendung von Energie aus der Umgebung, wie Licht, Wärme. Die Energie kann aber auch auf induktive Weise, wie z. B. einer QI-Verbindung, von einer externen Energieversorgungsquelle übertragen werden. Ferner kann Energie über das Netzkabel als POE-Energie zur Verfügung gestellt werden. Als Empfangsantenne der QI-Energieübertragung kann auch die Antennenspule, die zur Funkverbindung mit den RFID-Transpondern genutzt wird, entsprechend ausgebildet werden.

Es kann vorteilhaft sein, die Empfangseinheit nur temporär über eine drahtlose oder drahtgebundene Netzwerkverbindung mit dem Auswertesystem zu verbinden. Dadurch wird Energie eingespart für Zeiträume, in denen eine Überwachung der Leitungsverbindung nicht erforderlich ist. Die Einschaltung der Systemüberwachung kann in einer bevorzugten Ausführungsform von dem Auswertesystem durchgeführt werden, sobald dies sinnvoll oder notwendig ist. Die Überwachung kann auch eingeleitet werden, wenn an einer Leitungsverbindung ein besonderes Ereignis stattfindet, z. B. eine Lageänderung oder Änderung der Leitungsverbindung bei Arbeiten an einem Verteilersystem. Die Feststellung einer Lageänderung erfolgt vorzugsweise über einen Sensor zur Lage- oder Bewegungserfassung an der Leitungsverbindung. Damit ist es auch möglich, die Überwachung selbsttätig einzuschalten, sobald von einem Techniker eine Leitungsverbindung aus einer Kupplung eines Systemgerätes entfernt wird oder eingesteckt wird.

Vorzugsweise wird mit dem Start der Überwachung der Leitungsverbindung auch eine Energieübertragung zur Empfangseinheit ausgelöst.

Obgleich eine RFID-Funkübertragung bevorzugt wird, kann die Erfindung auch verwendet werden, wenn die Identifizierung eines Systemgerätes mittels eines sonstigen Codes herstellbar ist, beispielsweise durch optische Auslesung eines Barcodes oder QR-Codes an einem Systemgerät.

Auch eine kontaktbehaftete Übertragung eines Codes von einem Systemgerät auf eine Leitungsverbindung ist im Rahmen der Erfindung möglich.

Die mit der Leitungsverbindung gekoppelte Empfangseinheit und die verwendeten Spulen können eine räumliche Einheit mit der Leitungsverbindung bilden. Alternativ kann auch eine temporäre Verbindung bevorzugt sein.

Die Erfindung betrifft auch eine Leitungsverbindung zur temporären Verbindung zweier Systemgeräte zur Übertragung von Daten, elektrischer Energie, fließfähigen Stoffen oder Gasen zwischen Systemgeräten, wobei die Leitungsverbindung mit wenigstens einem Anschluss eines Systemgerätes verbindbar ist, der eine Codierung aufweist, die bei Anschluss der Leitungsverbindung an das Systemgerät erfassbar ist. Eine solche Leitungsverbindung enthält eine Empfangseinheit zur Erfassung der Codierung des Anschlusses sowie eine Energiespeichereinheit zur Energieversorgung der Empfangseinheit. Eine derartige Leitungsverbindung kann zur Verbindung von Systemgeräten in bestehende Systeme eingesetzt werden, die entsprechend angepasste RFID-Codespeicher aufweisen.

Schließlich bezieht sich die Erfindung auf ein Verfahren zur Herstellung und Überwachung einer Leitungsverbindung zwischen zwei Systemgeräten, bei dem bei Herstellung der Verbindung zwischen einem Systemgerät und der Leitungsverbindung ein dem Kupplungsanschluss des Systemgerätes zugeordneter RFID-Transponder von einer der Leitungsverbindung zugeordneten Empfangseinheit ausgelesen werden kann. Das Ergebnis der Auswertung des Codes des RFID-Transponders wird von der Empfangseinheit über ein drahtloses oder drahtgebundenes Übertragungsmedium an ein Auswertesystem übertragen, das den Ort der hergestellten Verbindung zwischen Systemgerät und Leitungsverbindung sowie den Verbindungszustand überwachen, speichern oder zur Anzeige bringen kann.

Vorzugsweise kann das Auswertesystem in Abhängigkeit von der Auswertung der Empfangseinheit Steuersignale zur Sperrung oder Freigabe der Leitungsverbindung zur Übertragung von Daten, Energie, Stoffen oder Gasen abgeben, indem z. B. Schalter oder Ventile freigegeben oder gesperrt werden.

Vorzugsweise ist der Empfangseinheit auch ein Lage- oder Bewegungsmodul zugeordnet, das Lageänderungen oder eine Bewegung der Leitungsverbindung erfassen kann, so dass die Überwachung der Leitungsverbindung daher in Abhängigkeit von der Feststellung einer Lageänderung oder Bewegung der Leitungsverbindung erfolgen kann.

In weiteren Ausführungsformen kann die Auslösung der Überwachung auch bei Änderung der Helligkeit im Raum (Erfassung durch Lichtsensor), durch Geräuscherfassung mittels Mikrofonen oder auch durch sonstige durch Sensoren erfassbare Änderungen des Umgebungszustands erfolgen.

Die Erfindung wird nachstehend anhand eines Ausführungsbeispiels näher erläutert. Es zeigen:
- Fig. 1: eine erste Ausführungsform der Erfindung, und
- Fig. 2: eine zweite Ausführungsform der Erfindung.

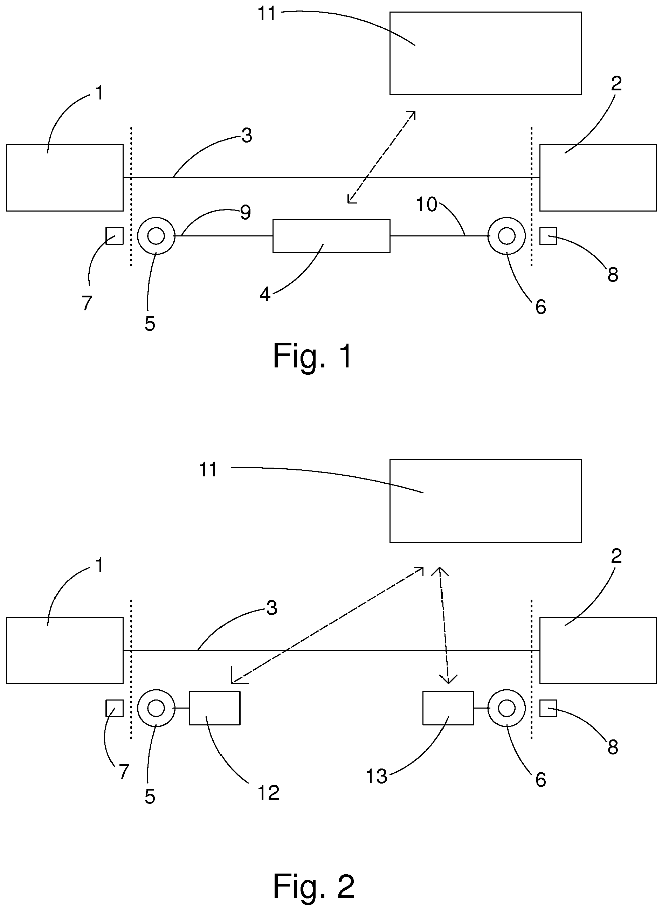

In Fig. 1 sind zwei Systemgeräte 1 und 2 durch eine Leitungsverbindung 3 miteinander gekoppelt. Die Systemgeräte 1 und 2, bei denen es sich um Wanddosen, Kameras, Patchfelder, Telefone, PCs, Sensoren, Aktuatoren, Roboter und andere zu identifizierende Geräte handeln kann, weisen jeweils einen RFID-Transponder 7 bzw. 8 an oder in der Nähe einer Steckkupplung der Leitungsverbindung 3 auf. Diese enthalten eine Gerätekennung, die das jeweilige Systemgerät eindeutig kennzeichnet.

Die Gerätekennung kann nicht nur durch eine RFID-Kennzeichnung, sondern auch durch andere Codierungsarten, wie Strichcodes, QR-Codes, mechanische Codeelemente, realisiert sein, wenn die Codeelemente durch entsprechend angepasste Erfassungsmöglichkeiten an der Leitungsverbindung erfassbar sind.

Bei einer nicht dargestellten Ausführung kann die Erfindung in gleicher Weise auch eingesetzt werden, wenn nur eines der Systemgeräte über eine Kupplung mit einer Leitungsverbindung zu verbinden ist, während die Leitungsverbindung an dem anderen Systemgerät permanent mit dem Gerät verbunden ist.

Parallel zur Leitungsverbindung 3 verläuft in dem Beispiel der Fig. 1 eine Anordnung, bestehend aus einer Empfangseinheit 4 und zwei elektrischen Leitungsabschnitten 9 und 10, die von der Empfangseinheit 4 auf Spulen 5 bzw. 6 geführt sind, die den Enden der Leitungsverbindung bzw. den daran sich befindenden Steckern zugeordnet sind. Die Spulen 5 und 6 werden durch die Empfangseinheit 4 aktiviert und treten in Kommunikationsverbindung mit RFID-Transpondern 7 bzw. 8 an den Systemgeräten 1 und 2, indem von den Antennen 5, 6 Sendeenergie an die RFID-Transponder 7 und 8 übertragen wird und daraufhin die eingespeicherten Identifikationscodes an die Antennen 5, 6 zurückübertragen und von der Empfangseinheit 4 aufgenommen werden. Die von der Empfangseinheit 4 empfangenen Daten können dann über eine Kommunikationsverbindung an ein Auswertesystem 11 übertragen werden. Die Verbindung von der Empfangseinheit 4 zum Auswertesystem 11 kann über eine Funkverbindung realisiert werden. Die Verbindung kann jedoch auch per Draht über die Systemgeräte 1 oder 2 oder einer zusätzlichen Drahtverbindung hergestellt werden. Eine Funkverbindung ist jedoch bevorzugt, insbesondere für den Fall, dass die Leitungsverbindung 3 keine elektrische Leitungsverbindung ist, sondern ein nichtelektrischer Lichtleiter oder eine Leitungsverbindung für elektrische Energie, Fluidstoffe oder Gase.

Die Funkverbindung zwischen Empfangseinheit 4 und Auswertesystem 11 kann entweder direkt erfolgen oder über standardisierte Funknetzwerke, wie WLAN, vermaschte Netzwerke, wie ZigBee, Zwave, 6LowPAN und andere bekannte Verfahren.

Die Empfangseinheit 4 und die Spulen 5, 6 sowie die Leitungsabschnitte 9 und 10 können fester Bestandteil der Leitungsverbindung 3 sein. Sie können jedoch auch davon lösbar sein oder nachträglich mittels Schellen, Clips, Kabelbindern oder ähnlichem an der Leitungsverbindung befestigt werden.

Da die Empfangseinheit 4 eine aktive Einheit bildet, benötigt diese Betriebsenergie, die in Form einer Batterie, eines Akkumulators oder auch einer Energiezufuhr von außen realisiert werden kann. Aufgrund der nur geringen Leistung derartiger Geräte kann die Energie aus photoelektrischen Zellen oder auch anderen an sich bekannten Energiequellen zur Verfügung gestellt werden. Ein bevorzugtes Verfahren ist die Übertragung der Energie über die Spulen 5 und 6 aus einem der Systemgeräte 1 oder 2, wobei insbesondere das induktive QI-Verfahren zur drahtlosen Energieübertragung zur Anwendung kommen kann. Bei einer elektrischen Netzwerkverbindung der Leitungsverbindung 3 kann auch das sogenannte POE-Verfahren (Power over Ethernet) zur Anwendung kommen, bei dem elektrische Energie über das Netzwerkkabel übermittelt wird.

In Fig. 2 ist eine zweite Ausführungsform der Erfindung dargestellt, bei der statt einer einzigen Empfangseinheit 4 zwei Empfangseinheiten 12, 13 verwendet werden, die jeweils unmittelbar an den Enden der Leitungsverbindung 3 angeordnet sind. Dies empfiehlt sich insbesondere für den Fall, in dem die Leitungsverbindung 3 sehr lang ausgeführt ist, so dass die Zusatzelemente (Sende-/Empfangseinheiten, Energieversorgung) zu der Leitungsverbindung 3 jeweils nur an deren Enden vorzusehen sind. Diese können auch über lösbare Clipverbindungen an der Leitungsverbindung 3 befestigt werden. Die Funkverbindung zum Auswertesystem 11, die Energiezufuhr zu den Empfangseinheiten 12 und 13 sowie die Kommunikationsverbindung zwischen den Spulen 5, 6 und den Transpondern 7 und 8 können in gleicher Weise wie bei der Anordnung nach Fig. 1 ausgestaltet sein.

Das Auswertesystem 11 kann die gewünschte Kopplung der Systemgeräte 1 und 2 über die Leitungsverbindung 3 ständig überwachen. Die Überwachung kann jedoch auch in zeitlichen Abständen durchgeführt werden oder dann, wenn Änderungen der Anordnung durchgeführt werden sollen, indem z. B. die Leitungsverbindung 3 von einem Systemgerät auf ein anderes Systemgerät umgeschaltet werden soll. Um ein nicht aktives Überwachungssystem nach der Erfindung in den aktiven Zustand zu versetzen, sind der Empfangseinheit 4 bzw. den Empfangseinheiten 12 und 13 daher vorzugsweise Bewegungssensoren zugeordnet, die eine Lageveränderung oder Bewegung der Leitungsverbindung 3 überwachen und bei Feststellung einer Bewegung ein Einschaltsignal an die Empfangseinheit abgeben oder an das Auswertesystem 11 übertragen. Durch das Auswertesystem 11 kann daher jegliche Änderung der Anordnung überwacht und protokolliert werden.

### Bezugszeichen

- 1: Systemgerät
- 2: Systemgerät
- 3: Leitungsverbindung
- 4: Empfangseinheit
- 5: Antennenspule
- 6: Antennenspule
- 7: RFID-Transponder
- 8: RFID-Transponder
- 9: Leitungsabschnitt
- 10: Leitungsabschnitt
- 11: Auswertesystem
- 12: Empfangseinheit
- 13: Empfangseinheit

## Patentansprüche

1. System zur Herstellung und Überwachung einer Leitungsverbindung (3) zwischen zwei Systemgeräten (1, 2), von denen wenigstens eines der Systemgeräte mit einem Kupplungsanschluss versehen ist, mit dem die Leitungsverbindung (3) verbindbar ist, wobei die Zuordnung der Leitungsverbindung (3) zu dem Kupplungsanschluss über eine RFID-Kopplung identifizierbar ist, und ein Auswertesystem (11) zur Erfassung und Überwachung des Verbindungszustandes einer Vielzahl von Leitungsverbindungen und Systemgeräten vorgesehen ist,
**dadurch gekennzeichnet, dass**
der Kupplungsanschluss wenigstens eines der Systemgeräte mit einem RFID-Transponder (7, 8) versehen ist, dass der Leitungsverbindung (3) eine mit dem Auswertesystem (11) verbindbare Empfangseinheit (4) zur Auswertung der Kommunikation mit dem RFID-Transponder (7, 8) zugeordnet ist und dass die Empfangseinheit (4) mit einem Energiespeicher versehen ist oder mit einer Energieversorgungseinheit koppelbar ist.

2. System nach Anspruch 1, **dadurch gekennzeichnet, dass**
die Leitungsverbindung (3) an einem oder beiden Enden jeweils eine Antennenspule (5, 6) zur Funkverbindung mit dem RFID-Transponder (7, 8) in dem Systemgerät oder den Systemgeräten (1, 2) aufweist, wobei die Antennenspule (5, 6) mit der Empfangseinheit (4) elektrisch verbunden ist.

3. System nach Anspruch 3, **dadurch gekennzeichnet, dass**
jedem Ende der Leitungsverbindung (3) eine Empfangseinheit (12, 13) zugeordnet ist, die mit dem Auswertesystem (11) verbindbar ist.

4. System nach Anspruch 2, **dadurch gekennzeichnet, dass**
wenigstens eine der Antennenspulen (5, 6) zusätzlich zur Kommunikation mit einer in einem Systemgerät angeordneten drahtlosen Energieübertragungseinheit ausgebildet ist.

5. System nach Anspruch 2, **dadurch gekennzeichnet, dass**
die Energieversorgungseinheit eine Batterie oder ein Modul zur Erfassung von Energie aus der Umgebung enthält.

6. System nach Anspruch 2, **dadurch gekennzeichnet, dass**
die Empfangseinheit wenigstens temporär über eine drahtlose oder drahtgebundene Netzwerkverbindung mit dem Auswertesystem verbindbar ist.

7. System nach Anspruch 1, **dadurch gekennzeichnet, dass**
der Leitungsverbindung (3) ein Modul zur Lage- oder Bewegungserfassung oder des Licht- oder Geräuschpegels räumlich zugeordnet ist, und dass die Überwachung der Leitungsverbindung (3) zwischen den Systemgeräten (1, 2) bei Feststellung einer Lageänderung oder Bewegung der Leitungsverbindung (3) oder einer Licht- oder Geräuschpegeländerung an der Leitungsverbindung (3) gestartet wird.

8. System nach Anspruch 7, **dadurch gekennzeichnet, dass**
mit dem Start der Überwachung der Leitungsverbindung (3) auch eine Energieübertragung zur Empfangseinheit ausgelöst wird.

9. System nach Anspruch 1, **dadurch gekennzeichnet, dass**
anstelle einer RFID-Verbindung eine kontaktbehaftete Codeübertragung verwendet wird.

10. System nach Anspruch 2, **dadurch gekennzeichnet, dass**
die Energieversorgung der Empfangseinheit über einen elektrischen Kontakt des Kupplungsanschlusses erfolgt.

11. System nach Anspruch 1, **dadurch gekennzeichnet, dass**
die Empfangseinheit mit der Leitungsverbindung eine räumliche Einheit bildet.

12. System nach Anspruch 1, 2 oder 3, **dadurch gekennzeichnet, dass**
die Empfangseinheit und oder die Antennenspulen über eine lösbare Clip-Verbindung mit der Leitungsverbindung koppelbar sind.

13. Leitungsverbindung (3) zur temporären Verbindung zweier Systemgeräte (1, 2) zur Übertragung von Daten, elektrischer Energie, fließfähigen Stoffen oder Gasen zwischen den Systemgeräten (1, 2), wobei die Leitungsverbindung (3) mit wenigstens einem Anschluss eines Systemgerätes verbindbar ist, der eine Codierung aufweist, die bei Anschluss der Leitungsverbindung (3) an das Systemgerät (1, 2) erfassbar ist, **dadurch gekennzeichnet, dass**
die Leitungsverbindung (3) mit einer mit einer Auswerteeinheit (11) in Kommunikationsverbindung bringbare Empfangseinheit (4, 12, 13) zur Erfassung der Codierung des Anschlusses versehen ist, und dass die Empfangseinheit (4, 12, 13) eine Energiespeichereinheit zur Energieversorgung der Empfangseinheit aufweist.

14. Verfahren zur Herstellung und Überwachung einer Leitungsverbindung (3) zwischen zwei Systemgeräten (1, 2), von denen wenigstens eines der Systemgeräte (1, 2) mit einem Kupplungsanschluss versehen ist, mit dem die Leitungsverbindung (3) verbindbar ist, wobei die Zuordnung der Leitungsverbindung (3) zu dem Kupplungsanschluss über eine RFID-Kopplung identifizierbar ist,
**dadurch gekennzeichnet, dass**
bei Herstellung der Verbindung zwischen einem Systemgerät (1, 2) und einer Leitungsverbindung (3) ein dem Kupplungsanschluss zugeordneter RFID-Transponder (7, 8) von einer der Leitungsverbindung (3) zugeordneten Empfangseinheit (4, 12, 13) ausgelesen werden kann, dass das Ergebnis der Auswertung des Codes des RFID-Transponders (7, 8) von der Empfangseinheit (4, 12, 13) über ein drahtloses oder drahtgebundenes Übertragungsmedium an ein Auswertesystem (11) übertragen wird, das den Ort der hergestellten Verbindung zwischen Systemgerät (1, 2) und Leitungsverbindung (3) sowie den Verbindungszustand überwacht, speichert und oder zur Anzeige bringt.

15. Verfahren nach Anspruch 14, **dadurch gekennzeichnet, dass**
das Auswertesystem (11) in Abhängigkeit von der Auswertung der Empfangseinheit (4, 12, 13) Steuersignale zur Sperrung oder Freigabe der Leitungsverbindung (3) zur Übertragung von Daten, Energie, Stoffen oder Gasen abgibt.

16. Verfahren nach Anspruch 14, **dadurch gekennzeichnet, dass**
der Empfangseinheit (4, 12, 13) ein Lage- oder Bewegungsmodul zugeordnet ist, das Lageänderungen oder Bewegungen der Leitungsverbindung (3) erfasst und die Überwachung der Leitungsverbindung (3) in Abhängigkeit von der Feststellung einer Lageänderung oder Bewegung der Leitungsverbindung (3) erfolgt.
